# EUROPÄISCHE PATENTSCHRIFT

(11) **EP 1 214 618 B1**
(45) Veröffentlichungstag und Bekanntmachung des Hinweises auf die Patenterteilung: **29.10.2003**
(21) Anmeldenummer: 00975799.8
(22) Anmeldetag: 21.09.2000
(51) Int. Cl.: G02B 6/42, H01S 5/022

(54) **ELEKTROOPTISCHES MODUL MIT EXTERNEN ELEKTRONISCHEN BAUELEMENTEN**
ELECTRO-OPTICAL MODULE WITH EXTERNAL ELECTRONICAL ELEMENTS
MODULE ELECTRO-OPTIQUE COMPRENANT DES ELEMENTS ELECTRONIQUES EXTERNES

(30) Priorität: 22.09.1999 DE 19946101
(43) Veröffentlichungstag der Anmeldung: 19.06.2002
(73) Patentinhaber: Infineon Technologies AG, 81669 München (DE)
(72) Erfinder: PANZER, Klaus, 93049 Regensburg (DE); HURT, Hans, 93049 Regensburg (DE)
(74) Vertreter: Müller, Wolfram Hubertus, Dipl.-Phys.
(86) Internationale Anmeldenummer: DE0003369
(87) Internationale Veröffentlichungsnummer: WO01022132

(56) Entgegenhaltungen:
- EP-A- 0 921 426
- WO-A-99/16133
- US-A- 5 239 605
- US-A- 5 539 767
- PATENT ABSTRACTS OF JAPAN vol. 010, no. 384 (E-466), 23. Dezember 1986 (1986-12-23) -& JP 61 174794 A (RICOH CO LTD), 6. August 1986 (1986-08-06) -& US 4 926 433 A (SENMA TOHITAKA ET AL.) 15. Mai 1990 (1990-05-15)

## Beschreibung

Die Erfindung bezieht sich auf ein elektrooptisches Modul mit einem Gehäuse, in dem eine Trägerplatte mit mindestens einem optischen Element, elektrischen Schaltungselementen und elektrischen Anschlußelementen untergebracht ist.

Ein elektrooptisches Modul dieser Art ist in der europäischen Patentanmeldung EP 0 646 816 A2 beschrieben. Bei diesem bekannten Modul ist im Gehäuse eine Trägerplatte mit einem optischen Element quer zur optischen Achse des Moduls so ausgerichtet angeordnet, daß das optische Element auf der optischen Achse liegt. Die Trägerplatte des bekannten Moduls ist nach Art einer gedruckten Leiterplatte ausgebildet und weist elektronische Bauelemente auf, die über gedruckte Leiterbahnen miteinander verbunden sind. Zusätzlich ist die Trägerplatte des bekannten Moduls an einer Stirnseite mit elektrischen Anschlußelementen versehen. Mit diesen elektrischen Anschlußelementen kann das bekannte elektrooptische Modul elektrisch beispielsweise mit Leiterbahnen auf einer gedruckten Schaltungsplatte in üblicherweise verbunden werden, indem das Modul auf die gedruckte Schaltungsplatte aufgesetzt wird. Die Zahl der auf der Trägerplatte unterzubringenden elektrischen Schaltungselemente ist bei vorgegebener Bauform des Gehäuses des bekannten elektrooptischen Moduls beschränkt.

Sollen dem bekannten elektrooptischen Modul weitere elektrische Schaltungselemente zugeordnet werden, dann bietet es sich an, diese weiteren elektrischen Schaltungselemente auf einer zusätzlichen Leiterplatte unterzubringen und diese zusätzliche Leiterplatte hinter (bezogen auf die optische Achse) dem elektrooptischen Modul auf eine gedruckte Schaltungsplatte aufzusetzen; über die gedruckte Schaltungsplatte erfolgt die elektrische Verbindung mit dem elektrooptischen Modul. Dies erfordert nicht nur zusätzlichen Aufwand, sondern schafft auch zusätzlichen Platzbedarf auf der gedruckten Schaltungsplatte; außerdem können durch die Leitungsführung von der zusätzlichen Leiterplatte über die gedruckte Leiterplatte zu dem elektrooptischen Modul und umgekehrt negative Auswirkungen auf zu übertragene Signale bzw. unerwünschte Beeinflussungen der Schaltung mit den Schaltungselementen hervorgerufen werden.

Die US 4 926 433 A beschreibt eine Lasereinheit für einen Laserdrucker, bei der auf einer Trägerplatte neben einer Laserdiode weitere elektrische Schaltungselemente angeordnet sind. Die Schaltungselemente sind dabei an der der Lasereinheit abgewandten Seite der Trägerplatte angeordnet. Allerdings befindet sich die Trägerplatte nicht innerhalb eines Gehäuses.

Der Erfindung liegt die Aufgabe zugrunde, ein elektrooptisches Modul mit einem Gehäuse mit einer Trägerplatte mit unter anderem elektrischen Schaltungselementen so auszugestalten, daß das elektrooptische Modul mit weiteren elektrischen Schaltungselementen mit einem vergleichsweise geringen Aufwand unter Beibehaltung einer kompakten Bauform ausgerüstet werden kann.

Diese Aufgabe wird durch ein elektrooptisches Modul mit den Merkmalen den Anspruchs 1 und ein elektroopisches Modul mit den Merkmalen des Anspruchs 2 gelöst.

Danach sind zur Lösung der angegebenen Aufgabe bei einem elektrooptischen Modul weitere elektrische Schaltungselemente auf einer Schaltungsplatine angeordnet, die entweder außen an der Wandung des Gehäuses des elektrooptischen Moduls befestigt ist oder die ein Teil der Wandung des Gehäuses des elektrooptischen Moduls ist. Die weiteren elektrischen Schaltungselemente sind dabei außerhalb des Gehäuses auf der Schaltungsplatine angeordnet und die Schaltungsplatine ist elektrisch unmittelbar mit der Trägerplatte verbunden.

Ein wesentlicher Vorteil der erfindungsgemäßen Lösung besteht darin, daß sich die weiteren elektrischen Schaltungselemente in einem kleinsten denkbaren Abstand vom Gehäuse des elektrooptischen Moduls befinden, indem sie auf einer auf der Wandung des Gehäuses befestigten oder einen Teil der Wandung ausbildenden Schaltungsplatine außerhalb des Gehäuses angeordnet sind; die Leitungsführung zwischen der Trägerplatte und der Schaltungsplatine ist daher sehr kurz, so daß Störbeeinflussungen durch die elektrischen Verbindungen weitgehend unterbunden sind. Ein weiterer Vorteil ist darin zu sehen, daß aufgrund der unmittelbaren Verbindung der Schaltungsplatine mit der Trägerplatte der Raumbedarf für die Schaltungsplatine und die weiteren Schaltungselemente klein ist.

Bei der Erfindungsvariante, bei der die Schaltungsplatine außen an der Wandung des Gehäuses befestigt ist, kann die Schaltungsplatine mit den weiteren elektrischen Schaltungselementen in üblicherweise bestückt und dann an der Wandung des Gehäuses befestigt werden.

Die Erfindungsvariante, bei der die Schaltungsplatine ein Teil der Wandung des Gehäuses des elektrooptischen Moduls ist, ist im Hinblick auf den Raumbedarf besonders vorteilhaft. Bei dieser Erfindungsvariante wird also auf eine gesonderte Schaltungsplatine zur Aufnahme der weiteren elektrischen Schaltungselemente überhaupt verzichtet, indem ein Teil der Wandung des Gehäuses als Schaltungsplatine benutzt wird.

Bei dem erfindungsgemäßen elektrooptischen Modul können Trägerplatte und Schaltungsplatine in unterschiedlicher Weise und räumlicher Anordnung zueinander im bzw. am elektrooptischen Modul angeordnet sein. Als besonders vorteilhaft wird es jedoch angesehen, wenn die Trägerplatte und Schaitungsplatine in parallel zueinander liegenden Ebenen quer zur optischen Achse des elektrooptischen Moduls ausgerichtet angeordnet sind und die Schaltungsplatine an ihrer einen Stirnseite äußere elektrische Anschlußteile des elektrooptischen Moduls aufweist. Diese Ausführungsform zeichnet sich durch einen besonders kompakten Aufbau aus. Als Stirnseite ist hier die untere Kante des Moduls bezeichnet, an der die Befestigung auf der gedruckten Schaltungsplatte erfolgt.

Dieser kompakte Aufbau wird noch dadurch gefördert, daß die Schaltungsplatine im Bereich der der Stirnseite mit den äußeren elektrischen Anschlußteilen gegenüberliegenden Stirnseite elektrisch mit den elektrischen Anschlußelementen der Trägerplatte verbunden ist.

Zur weiteren Erläuterung der Erfindung ist in
Figur 1 in einer Seitenansicht schematisch ein Ausführungsbeispiel eines elektrooptischen Moduls gemäß der Erfindung und in
Figur 2 ein weiteres Ausführungsbeispiel des erfindungsgemäßen elektrooptischen Moduls in ebenfalls schematischer Darstellung gezeigt.

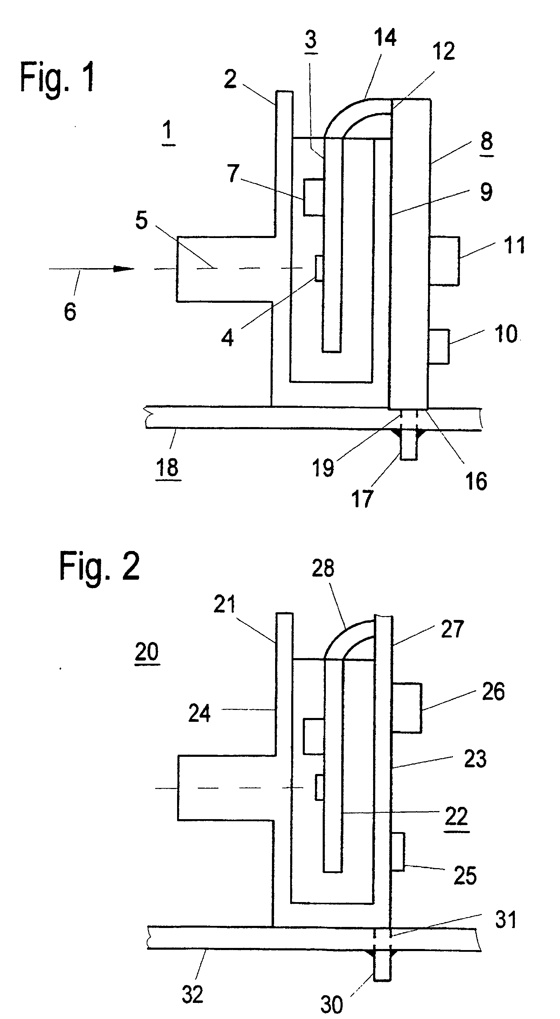

Das in Figur 1 dargestellte elektrooptische Modul 1 weist ein Gehäuse 2 auf, in dem eine Trägerplatte 3 untergebracht ist. Die Trägerplatte 3 ist mit einem optischen Element 4 versehen, das im Zuge einer optischen Achse 5 des elektrooptischen Moulds 1 angeordnet ist. Bei dem optischen Element 4 kann es sich beispielsweise um einem Lichtempfänger handeln, dem in Richtung eines Pfeiles 6 in nicht weiter dargestellter Form Licht zugeführt wird. Außerdem ist die Trägerplatte 3 bei dem dargestellten Ausführungsbeispiel mit elektrischen Schaltungselementen versehen, von denen in der Figur 1 der besseren Übersichtlichkeit halber nur ein Vorverstärker 7 dargestellt ist.

An dem Gehäuse 2 des dargestellten elektrooptischen Moduls 1 ist eine Schaltungsplatine 8 befestigt, indem diese an der Wandung 9 des Gehäuses 2 beispielsweise mittels Kleben angebracht ist. Vor der Befestigung der Schaltungsplatine 8 ist diese zweckmäßigerweise mit weiteren elektrischen Bauelementen bestückt, von denen in der Figur nur ein Widerstand 10 und ein Nachverstärker 11 gezeigt sind.

Die Schaltungsplatine 8 ist in üblicherweise mit in der Figur nicht dargestellten Leiterbahnen versehen und an dem Punkt 12 mit elektrischen Anschlußelementen 14 der Trägerplatte 3 elektrisch verbunden. An ihrer in der Figur 1 unteren einen Stirnseite 16 ist die Schaltungsplatine 8 mit äußeren elektrischen Anschlußteilen 17 versehen, von denen in der Figur 1 nur ein Schaltungsteil erkennbar ist.

Die Figur 1 zeigt ferner, daß das elektrooptische Modul 1 mit daran befestigter Schaltungsplatine 8 auf eine gedruckte Schaltungsplatte 18 aufgesetzt ist und mit seinen elektrischen Anschlußteilen 17 durch Bohrungen 19 in der gedruckten Schaltungsplatte 18 geführt ist. Durch Löten sind die elektrischen Anschlußteile 17 mit nicht weiter dargestellten Leiterbahnen auf der gedruckten Schaltungsplatte 18 verbunden.

Das in Figur 2 gezeigte elektrooptische Modul 20 weist ebenfalls ein Gehäuse 21 auf, in dem eine Trägerplatte 22 in einer Ausgestaltung und Bestückung ähnlich der Trägerplatte 3 gemäß Figur 1 untergebracht ist. Eine Wand 23 der Wandung 24 des Gehäuses 21 bildet hier die Schaltungsplatine; außen an der Wand 23 sind beispielsweise ein Widerstand 25 und ein Nachverstärker 26 angebracht sind. Die Wand 23 ist nach Art einer sogenannten MID (Molded Interconnect Device)-Anordnung ausgebildet und enthält demzufolge in ihrem Innern nicht dargestellte Leitungszüge und auch auf ihrer äußeren Fläche 27 nicht dargestellte Leiterbahnen. Mit den Leiterbahnen und Leitungszügen der Wand 23 sind einerseits die elektrischen Anschlußelemente 28 der Trägerplatte 22 und andererseits Anschlußteile 30 verbunden, die wiederum durch Bohrungen 31 in einer gedruckten Schaltung 32 geführt und dort verlötet sind. Zum Verlöten kann die Durchstecktechnik oder die SMD (Surface Mounted Devices)-Technik zur Anwendung gelangen.

## Patentansprüche

1. Elektrooptisches Modul mit einem Gehäuse, in dem
- eine Trägerplatte (3) mit mindestens einem optischen Element (4), elektrischen Schaltungselementen (7) und elektrischen Anschlußelementen (14) untergebracht ist,
**dadurch gekennzeichnet, daß**
- weitere elektrische Schaltungselemente (10, 11) auf einer Schaltungsplatine (8) angeordnet sind, die außen an der Wandung (9) des Gehäuses (2) des elektrooptischen Moduls (1) befestigt ist, wobei
- die weiteren elektrischen Schaltungselemente (10, 11) außerhalb des Gehäuses (2) auf der Schaltungsplatine (8) angeordnet sind, und
- die Schaltungsplatine (8) elektrisch unmittelbar mit der Trägerplatte (3) verbunden ist.

2. Elektrooptisches Modul mit einem Gehäuse, in dem
- eine Trägerplatte (22) mit mindestens einem optischen Element (4), elektrischen Schaltungselementen (7) und elektrischen Anschlußelementen (28) untergebracht ist,
**dadurch gekennzeichnet, daß**
- weitere elektrische Schaltungselemente (25, 26) auf einer Schaltungsplatine angeordnet sind, die ein Teil (23) der Wandung (24) des Gehäuses (21) des elektrooptischen Moduls (20) ist, wobei
- die weiteren elektrischen Schaltungselemente (25, 26) außerhalb des Gehäuses (21) auf der Schaltungsplatine (23) angeordnet sind, und
- die Schaltungsplatine (23) elektrisch unmittelbar mit der Trägerplatte (22) verbunden ist.

3. Elektrooptisches Modul nach Anspruch 1 oder 2,
**dadurch gekennzeichnet, daß**
- die Trägerplatte (3; 22) und Schaltungsplatine (8; 23) in parallel zueinander liegenden Ebenen quer zur optischen Achse (5) des elektrooptischen Moduls (1; 20) ausgerichtet angeordnet sind und
- die Schaltungsplatine (8; 23) an ihrer einen Stirnseite (16) äußere elektrische Anschlußteile des elektrooptischen Moduls (1; 20) aufweist.

4. Elektrooptisches Modul nach Anspruch 3,
**dadurch gekennzeichnet, daß**
- die Schaltungsplatine (8; 23) im Bereich der der einen Stirnseite (16) mit den äußeren elektrischen Anschlußteilen (17; 30) gegenüberliegenden Stirnseite elektrisch mit den elektrischen Anschlußelementen (14, 28,) der Trägerplatte (3; 22) verbunden ist.

## Claims

1. Electro-optical module comprising a housing, in which
- a support plate (3) having at least one optical element (4), electric circuit elements (7) and electric connecting elements (14) is accommodated,
**characterized in that**
- further electric circuit elements (10, 11) are arranged on a circuit board (8) which is fixed to the outside of the wall (9) of the housing (2) of the electro-optical module (1),
- the further electric circuit elements (10, 11) being arranged outside the housing (2), on the circuit board (8), and
- the circuit board (8) being electrically connected directly to the support plate (3).

2. Electro-optical module comprising a housing, in which
- a support plate (22) having at least one optical element (4), electric circuit elements (7) and electric connecting elements (28) is accommodated,
**characterized in that**
- further electric circuit elements (25, 26) are arranged on a circuit board which is a part (23) of the wall (24) of the housing (21) of the electro-optical module (20),
- the further electric circuit elements (25, 26) are arranged outside the housing (21), on the circuit board (23), and
- the circuit board (23) is electrically connected directly to the support plate (22).

3. Electro-optical module according to Claim 1 or 2,
**characterized in that**
- the support plate (3; 22) and circuit board (8; 23) are arranged in planes lying parallel to each other and aligned transversely with respect to the optical axis (5) of the electro-optical module (1; 20), and
- the circuit board (8; 23) has external electric connecting parts of the electro-optical module (1; 20) at one of its ends (16).

4. Electro-optical module according to Claim 3,
**characterized in that**
- the circuit board (8; 23) is electrically connected to the electric connecting elements (14, 28) of the support plate (3; 22) in the region of the end lying opposite the one end (16) having the external electric connecting parts (17; 30).

## Revendications

1. Module électro-optique comprenant un boîtier dans lequel
- il est logé une plaque-support (3) ayant au moins un élément (4) optique, des éléments (7) électriques de circuit et des éléments (14) électriques de connexion,
**caractérisé en ce que**
- d'autres éléments (10, 11) électriques de circuit sont disposés sur une platine (8) de circuit qui est fixée à l'extérieur sur la paroi (9) du boîtier (2) du module (1) électro-optique,
- les autres éléments (10, 11) électriques de circuit étant disposés à l'extérieur du boîtier (2) sur la platine (8) de circuit, et
- la platine (8) de circuit est reliée électriquement directement à la plaque-support (3).

2. Module électro-optique comprenant un boîtier dans lequel
- il est logé une plaque-support (22) ayant au moins un élément (4) optique, des éléments (7) électriques de circuit et des éléments (28) électriques de connexion,
**caractérisé en ce que**
- d'autres éléments (25, 26) électriques de circuit sont disposés sur une platine de circuit qui constitue une partie (23) de la paroi (24) du boîtier (21) du module (20) électro-optique,
- les autres éléments (25, 26) électriques de circuit étant disposés à l'extérieur du boîtier (21) sur la platine (23) de circuit, et
- la platine (23) de circuit est reliée électriquement directement à la plaque-support (22).

3. Module électro-optique suivant la revendication 1 ou 2,
**caractérisé en ce que**
- la plaque-support (3 ; 22) et la platine (8 ; 23) de circuit sont disposées dans des plans parallèles en étant dirigées transversalement à l'axe (5) optique du module (1 ; 20) électro-optique et
- la platine (8 ; 23) de circuit a, sur l'un de ses côtés (16) frontaux, des parties extérieures de connexion électrique du module (1 ; 20) électro-optique.

4. Module électro-optique suivant la revendication 3,
**caractérisé en ce que**
- la platine (8 ; 23) de circuit est reliée, dans la zone des côtés frontaux opposés au côté (16) frontal ayant les parties (17 ; 30) extérieures de connexion électrique, électriquement aux éléments (14, 28) électriques de connexion de la plaque-support (3 ; 22).
